# EUROPEAN PATENT SPECIFICATION

(11) **EP 4 224 535 B1**
(45) Date of publication and mention of the grant of the patent: **01.01.2025**
(21) Application number: 20956036.6
(22) Date of filing: 18.11.2020
(51) Int. Cl.: H01L 31/049, H01L 31/048, H01L 31/056

(54) **PHOTOVOLTAIC MODULE BACK SHEET AND PHOTOVOLTAIC MODULE HAVING SAME**
RÜCKSEITENFOLIE FÜR FOTOVOLTAISCHES MODUL UND FOTOVOLTAISCHES MODUL DAMIT
FEUILLE ARRIÈRE DE MODULE PHOTOVOLTAÏQUE ET SYSTÈME PHOTOVOLTAÏQUE COMPRENANT CELLE-CI

(30) Priority: 30.09.2020 CN 202011062991
(43) Date of publication of application: 09.08.2023
(73) Proprietor: Suzhou First PV Material Co., Ltd., Suzhou, Jiangsu 215555 (CN)
(72) Inventor: YANG, Xiaoxu, Suzhou, Jiangsu 215555 (CN); WANG, Fucheng, Suzhou, Jiangsu 215555 (CN); ZHAO, Yong, Suzhou, Jiangsu 215555 (CN); YU, Xiaohua, Suzhou, Jiangsu 215555 (CN); LI, Nannan, Suzhou, Jiangsu 215555 (CN)
(74) Representative: Zacco GmbH
(86) International application number: PCT/CN2020/129837
(87) International publication number: WO 2022/068017

(56) References cited:
- CN-A- 106 024 946
- CN-A- 106 057 977
- CN-A- 106 218 155
- CN-A- 106 328 744
- CN-A- 109 796 806
- CN-A- 109 849 445
- JP-A- 2020 032 545
- US-A1- 2011 277 834
- US-A1- 2019 067 501

## Description

### Technical Field

The present disclosure relates to the photovoltaic field, and in particular to a photovoltaic module backplane and a photovoltaic module thereof.

### Background

The installation site of a photovoltaic module has developed from large-scale centralized power stations to distributed power stations. The installation environments and sites of distributed power stations are diversified, and generally are commonly seen in densely inhabited areas such as a building roof, a building outer wall, and a highway, etc.

In order to improve the aesthetics of the photovoltaic module, in the related art, the following processing is generally performed:
a prior art document provides a method for preparing a front panel of a solar glass curtain wall; in the preparation method, a laser-treated polymer membrane is used as a decorative layer, and is applied to the front panel of the solar glass curtain wall.

Another prior art document provides a method for manufacturing a front panel of a solar assembly; in the manufacturing method, a pattern layer is manufactured by a UV transfer method, and is applied to the front panel of the solar assembly.

Still another prior art document provides a transparent thin-film solar assembly containing a colored art pattern, and the assembly uses a colored laminated material as a pattern layer.

US 2019/067501 A1 discloses a photovoltaic module backplane, comprising an insulating layer, a reflective layer, a first decorative layer and a first transparent protective layer which are stacked in sequence.

Problems existing in the methods are: the methods for improving the aesthetics of the photovoltaic module all use a single decorative material, and thus the photovoltaic module has the problems of easy delamination and poor weather resistance in the application process. Moreover, most of the methods are directed to the decoration of a thin film assembly, and no solution for the decoration of a crystalline silicon assembly is found; and the methods only consider the decoration of the front panel of the photovoltaic module, but does not consider the decoration of the back face thereof.

In view of the existence of the problems, there is a need to develop a photovoltaic module which is not easy to delaminate, has good weather resistance and is aesthetic.

### Summary

A main object of the present disclosure is to provide a photovoltaic module backplane and a photovoltaic module thereof, so as to solve the problems of easy delamination and poor weather resistance of the existing photovoltaic module backplane.

In order to achieve the object, one aspect of the present disclosure provides a photovoltaic module backplane, and the photovoltaic module backplane includes an insulating layer, a reflective layer, a first decorative layer and a first transparent protective layer which are stacked in sequence. A matrix resins forming the reflective layer and the first decorative layer are fluorine-containing resins.

Further, the fluorine-containing resin is a copolymerized fluororesin containing tetrafluoroethylene chain segments and/or chlorotrifluoroethylene chain segments; preferably the contents of fluorine elements in the matrix resins of the reflective layer and the first decorative layer are 3 to 15 wt% and 5 to 20 wt% in sequence.

Further, raw materials for forming the first decorative layer further comprise a pigment, the L value of the pigment is 10 to 70, the a value of the pigment is -20 to 20, and the b value of the pigment is -40 to 0, and the difference between the Lab value of the pigment and the Lab value of a target battery cell is ±5%.

Further, the photovoltaic module backplane further comprises: an undercoat layer and a second decorative layer. And the undercoat layer is provided on the surface of the insulating layer away from the reflective layer; and the second decorative layer is provided on the surface of the undercoat layer away from the insulating layer.

Further, the photovoltaic module backplane further comprises a second transparent protective layer, wherein the second transparent protective layer is provided on the surface of the second decorative layer away from the undercoat layer.

Further, the first transparent protective layer has a thickness of 1 to 20 µm, and the second transparent protective layer has a thickness of 10 to 50 µm.

Further, raw materials for forming the reflective layer comprise a white filler and a dispersant. And preferably, based on 100 parts by weight, in the raw materials for forming the reflective layer, the amount of the white filler is 10 to 50 parts, and the amount of the dispersant is 0.5 to 5 parts.

Another aspect of some embodiments of the present disclosure further provides a photovoltaic module, comprising a backplane, while the backplane is the photovoltaic module backplane provided by the present disclosure.

By applying the technical solutions of the present disclosure, forming the reflective layer and the first decorative layer with same matrix resins can greatly improve the compatibility between the reflective layer and the first decorative layer, and reduce the risk of delamination of the photovoltaic module backplane. Moreover, the fluorine-containing resin belongs to a thermoplastic resin, and has good weather resistance, chemical stability, flame resistance and low friction coefficient, etc.; therefore, selecting the fluorine-containing resin as the matrix resins of the reflective layer and the first decorative layer, and providing the first transparent protective layer facilitate great improvement of the ultraviolet radiation rejection, weather resistance, flame resistance, aesthetics and insulation of the photovoltaic module. In addition, since patterns in the first decorative layer can fill gaps and edges of a target photovoltaic module, the photovoltaic module backplane has better aesthetics. On this basis, the photovoltaic module backplane with the described structure has advantages of being not prone to delaminate, low ultraviolet transmittance, good weather resistance, good flame resistance and good insulation and aesthetic product, etc.

### Brief Description of the Drawings

The drawings of the description, constituting a part of some embodiments of the present disclosure, are used for providing further understanding of some embodiments of the present disclosure, and the illustrative embodiments of the present disclosure and illustrations thereof are used to explain some embodiments of the present disclosure, rather than constitute inappropriate limitation on some embodiments of the present disclosure. In the drawing:

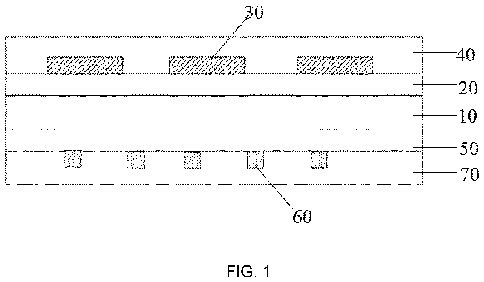

Fig. 1 shows a schematic structural diagram of a photovoltaic module backplane provided according to typical embodiments of the present disclosure.

The described accompanying drawing comprises the following reference signs:
10. Insulating layer; 20. Reflective layer; 30. First decorative layer; 40. First transparent protective layer; 50. Undercoat layer; 60. Second decorative layer; 70. Second transparent protective layer.

### Detailed Description of the Embodiments

As described in the Background, the existing photovoltaic module backplanes have the problem of easy delamination. In order to solve the technical problem, the present disclosure provide a photovoltaic module backplane. As shown in Fig. 1, the photovoltaic module backplane comprises an insulating layer 10, a reflective layer 20, a first decorative layer 30 and a first transparent protective layer 40 which are stacked in sequence, wherein matrix resins forming the reflective layer 20 and the first decorative layer 30 are fluorine-containing resins.

Forming the insulating layer 10, the reflective layer 20 and the first decorative layer 30 with same matrix resins can greatly improve the compatibility between the insulating layer 10, the reflective layer 20 and the first decorative layer 30, and reduce the risk of delamination of the photovoltaic module backplane. Moreover, the fluorine-containing resin has good weather resistance, chemical stability, flame resistance and low friction coefficient, etc.; therefore, selecting the fluorine-containing resin as the matrix resins of the insulating layer 10, the reflective layer 20 and the first decorative layer 30, and providing the first transparent protective layer 40 facilitate great improvement of the ultraviolet radiation rejection, weather resistance, flame resistance, aesthetics and insulation of the photovoltaic module. In addition, since patterns in the first decorative layer 30 can fill gaps and edges of a target photovoltaic module, the photovoltaic module backplane has better aesthetics. On this basis, the photovoltaic module backplane with the described structure has advantages of being not prone to delaminate, low ultraviolet transmittance, good weather resistance, good flame resistance and good insulation and aesthetic product, etc.

In preferred embodiments, the fluorine-containing resin is preferably a copolymerized fluororesin containing tetrafluoroethylene chain segments and/or chlorotrifluoroethylene chain segments. To a certain extent, the larger the content of fluorine elements in the fluorine-containing resin is, the better the weather resistance of the photovoltaic backplane is. However, when the fluorine content exceeds a certain limit, the fluorine-containing resin will have a strong rigidity, meanwhile the flexibility thereof becomes relatively poor; therefore, in order to consider the mechanical strength, flexibility and delamination resistance of the photovoltaic module backplane while improving the weather resistance thereof, more preferably, the contents of fluorine elements in the matrix resins of the reflective layer 20 and the first decorative layer 30 are 3 to 15 wt% and 5 to 20 wt% in sequence.

In order to further improve the delamination resistance and the ultraviolet radiation rejection of the photovoltaic backplane, preferably, the matrix resins forming an undercoat layer 50, a second decorative layer 60, a first transparent protective layer 40 and a second transparent protective layer 70 are fluorine-containing resins, and the contents of fluorine elements thereof are 1 to 10%, 5 to 15%, 8 to 15% and 3 to 15% in sequence.

Patterns in the first decorative layer 30 are used to fill gaps and edges of the target photovoltaic module, and thus in order to make the color of the first decorative layer less different from the color of a battery cell and to improve the aesthetics thereof, preferably, raw materials for forming the first decorative layer 30 further comprise a pigment, the L value of the pigment is 10 to 70, the a value of the pigment is -20 to 20, and the b value of the pigment is -40 to 0, and the difference between the Lab value of the pigment and the Lab value of a target battery cell is ±5%.

In order to further reduce the transmittance of the backplane to ultraviolet at 380 nm or less, in preferred embodiments, in parts by weight, raw materials for forming the first transparent protective layer 40 comprise 55 to 75 parts of fluorine-containing resin, 1 to 5 parts of UV absorber, 2 to 6 parts of light stabilizer and 5 to 8 parts of isocyanate curing agent; and raw materials for forming the second transparent protective layer 70 comprise 40 to 60 parts of fluorine-containing resin, 20 to 30 parts of polyester resin, 4 to 6 parts of light stabilizer and 4 to 7 parts of isocyanate curing agent.

In preferred embodiments, as shown in Fig. 1, the photovoltaic module backplane further comprises: an undercoat layer 50 and a second decorative layer 60, wherein the undercoat layer 50 is provided on the surface of the insulating layer 10 away from the reflective layer 20; and the second decorative layer 60 is provided on the surface of the undercoat layer 50 away from the insulating layer 10. The undercoat layer 50 on the one hand, facilitates protection of the insulating layer 10, and on the other hand, can also provide the second decorative layer 60 with a background color, thereby further improves the aesthetics of the photovoltaic module. Patterns on the second decorative layer 60 may be any pattern, such as letters, logos, publicity calligraphy and painting, etc. Preferably, the composition of the undercoat layer contains a fluorine-containing resin, a polyester resin, and an isocyanate curing agent. The undercoat layer with the composition has good adhesion performance with the insulating layer and the second decorative layer, thereby facilitating further improvement of the delamination resistance thereof.

In order to further improve the weather resistance of the photovoltaic module, preferably, as shown in Fig. 1, the photovoltaic module backplane further comprises a second transparent protective layer 70, wherein the second transparent protective layer 70 is provided on the surface of the second decorative layer 60 away from the undercoat layer 50. More preferably, compositions forming the first transparent protective layer 40 comprise a fluorine-containing resin, a UV absorber, a light stabilizer and an isocyanate curing agent; and compositions forming the second transparent protective layer 70 comprise a fluorine-containing resin, a polyester resin, a light stabilizer and an isocyanate curing agent.

In preferred embodiments, the thickness of the first transparent protective layer 40 is 1 to 20 µm, and the thickness of the second transparent protective layer 70 is 10 to 50 µm.

In preferred embodiments, raw materials for forming the reflective layer 20 comprise: a fluorine-containing resin, an inorganic reflective material and a first solvent; raw materials for forming the first decorative layer 30 and raw materials for forming the second decorative layer 60 both comprise: a fluorine-containing resin, a pigment and a second solvent. Raw materials for forming the first transparent protective layer 40 and raw materials for forming the second transparent protective layer 70 both comprise: a fluorine-containing resin, an auxiliary agent and a third solvent, wherein the auxiliary agent includes but is not limited to an ultraviolet-resistant auxiliary agent. Raw materials for forming the undercoat layer 50 comprise a fluorine-containing resin, a polyester resin and an isocyanate curing agent. Then, first decorative layer 30, second decorative layer 60, undercoat layer 50, first transparent protective layer 40 and second transparent protective layer 70 are formed in conventional manners such as spray coating, roller coating and screen printing. The solvents used in the preparation process of layers of the photovoltaic module backplane can be of common types in the art, which will not be elaborated herein.

In preferred embodiments, raw materials for forming the reflective layer 20 comprise a white filler and a dispersant. The addition of the dispersant can improve the dispersibility of the white filler, is useful to increase the reflectivity of the photovoltaic module to light, thereby improve the electrical performance thereof. More preferably, based on 100 parts by weight, in the raw materials for forming the reflective layer 20, the amount of the white filler is 10 to 50 parts, and the amount of the dispersant is 0.5 to 5 parts.

Another aspect of some embodiments of the present disclosure further provides a photovoltaic module, comprising a backplane, and the backplane is the photovoltaic module backplane provided by the present disclosure.

Forming the reflective layer 20 and the first decorative layer 30 with same matrix resins can greatly improve the compatibility between the reflective layer 20 and the first decorative layer 30, and reduce the risk of delamination of the photovoltaic module backplane. Moreover, the fluorine-containing resin belongs to a thermoplastic resin, and has good weather resistance, chemical stability, flame resistance and low friction coefficient, etc.; therefore, selecting the fluorine-containing resin as the matrix resins of the reflective layer 20 and the first decorative layer 30, and providing the first transparent protective layer 40 facilitate great improvement of the ultraviolet radiation rejection, weather resistance, flame resistance, aesthetics and insulation of the photovoltaic module. In addition, since patterns in the first decorative layer 30 can fill gaps and edges of a target photovoltaic module, the photovoltaic module backplane has better aesthetics. On this basis, the photovoltaic module backplane having the described structure has advantages of being not prone to delaminate, low ultraviolet transmittance, good weather resistance, good flame resistance and good insulation and aesthetic product, etc.

It is to be noted that embodiments in the present disclosure and features in the embodiments may be combined with one another without conflicts. Hereinafter, the present disclosure will be described in detail with reference to embodiments.

### Embodiment 1

The photovoltaic module backplane comprised an insulating layer 10, a reflective layer 20, a first decorative layer 30 and a first transparent protective layer 40 which were stacked in sequence.

A PET thin film was used as the insulating layer 10, extrusion coating was performed on the insulating layer 10, and after performing curing at a high temperature of 185°C, the reflective layer 20 was formed. In parts by weight, raw materials of the reflective layer 20 was consist of 55 parts of fluorine-containing resin (GK570 resin from Daikin Fluorochemicals Co., Ltd.), 35 parts of titanium dioxide (R706 from Dupont China Holding Co., LTd.), 10 parts of polyester resin (NPSN resin from Nan Ya Plastics Corporation) and 5 parts of isocyanate curing agent (N3400 curing agent from Covestro Polymers Co., LTd.).) The thickness of the reflective layer 20 was 15 mm, and the fluorine content thereof was 10%.

Extrusion coating was performed on the other face of the insulating layer 10, and after performing curing at a high temperature of 180°C, the undercoat layer 50 was formed. In parts by weight, raw materials of the undercoat layer 50 were consist of 40 parts of fluorine-containing resin (ZHM-2 resin from Shanghai Dongfu Chemical Technology, Co., LTd.), 30 parts of polyester resin (NPSN resin from Nan Ya Plastics Corporation), and 3 parts of isocyanate curing agent (N3400 curing agent from Covestro Polymers Co., LTd.). The thickness of the undercoat layer 50 was 5 mm, and the fluorine content thereof was 6%.

By means of a roller printing process, raw materials for forming the first decorative layer 30 were transferred onto the reflective layer 20, so as to form the first decorative layer. In parts by weight, raw materials of the first decorative layer 30 were consist of, in parts by weight, 45 parts of fluorine-containing resin (ZHM-5 resin from Shanghai Dongfu Chemical Technology, Co., LTd.), 15 parts of carbon black (M430 from Cabot Chemical Co., Ltd.), 20 parts of polyester resin (NPSN resin from Nan Ya Plastics Corporation) and 4.5 parts of isocyanate curing agent (N3400 curing agent from Covestro Polymers Co., LTd.). The thickness of the first decorative layer 30 was 5 mm, and the fluorine content thereof was 4%. The L value of the formed first decorative layer was 18, the a value thereof was 2, and the b value thereof was -5, and the first decorative layer had a color difference of <5% from a battery.

After extrusion coating, raw materials for forming the first transparent protective layer 40 were uniformly coated on the first decorative layer 30. And They were cured at a high temperature, and then completely covered the first decorative layer 30. In parts by weight, they were consist of 60 parts of fluorine-containing resin (41011 resin from Eternal Chemical (Kunshan) Co., Ltd.), 2 parts of UV absorber (UV326 from BASF AG, Germany), 4 parts of light stabilizer (Tinuvin329 from BASF AG, Germany) and 7.5 parts of isocyanate curing agent (N3400 curing agent from Covestro Polymers Co., LTd.). The thickness of the first transparent protective layer 40 was 20 mm, and the fluorine content thereof was 12%.

By means of a screen printing process, raw materials for forming the second decorative layer 60 were printed on the undercoat layer 50, to form the second decorative layer 60. In parts by weight, they were consist of 50 parts of fluorine-containing resin (JF-3X resin from Shanghai Dongfu Chemical Technology, Co., LTd.), 5 parts of organic pigment (K7090 from BASF AG, Germany), 30 parts of polyester resin (NPSN resin from Nan Ya Plastics Corporation) and 3.5 parts of isocyanate curing agent (N3400 curing agent from Covestro Polymers Co., LTd.). The thickness of the second decorative layer 60 was 3 mm, and the fluorine content thereof was 7%.

After extrusion coating, raw materials for forming the second transparent protective layer 70 were uniformly coated on the second decorative layer 60. And they were cured at a high temperature, and then completely covered the second decorative layer 60, to obtain the second transparent protective layer 70. In parts by weight, raw materials for forming the second transparent protective layer 70 were consist of 50 parts of fluorine-containing resin (DF-300 resin from Shanghai Dongfu Chemical Technology, Co., LTd.), 15 parts of polyester resin (NPSN resin from Nan Ya Plastics Corporation), 5 parts of light stabilizer and 6 parts of isocyanate curing agent (N3400 curing agent from Covestro Polymers Co., Ltd.). The thickness of the second transparent protective layer 70 was 15 mm, and the fluorine content thereof was 12%.

Regarding the backplane of the described structure, the transmittance of the first transparent protective layer 40 and the second transparent protective layer 70 to ultraviolet rays at 380 nm or less was tested according to a GB/T 2410-2008 method. The test result showed that the ultraviolet transmittance of the first transparent protective layer 40 and the second transparent protective layer 70 was 0.6% and 0.4%, respectively. After irradiation aging by ultraviolet 500 kWh according to GB/T 31034-2014, the decorative layers were not faded, and the yellowing index ΔYI of the protective layers on the surfaces was 3.4 (ΔYI<5); and after 3000 hours of double-85 accelerated aging (85°C, 85% humidity), the layers were not delaminated, and the whole solar assembly did not change color, which completely satisfied the outdoor use of conventional solar assemblies.

### Embodiment 2

The photovoltaic module backplane comprised an insulating layer 10, a reflective layer 20, a first decorative layer 30 and a first transparent protective layer 40 which are stacked in sequence.

A PET thin film was used as the insulating layer 10, extrusion coating was performed on the insulating layer 10, and after performing curing at a high temperature of 190°C, the reflective layer 20 was formed. In parts by weight, raw materials of the reflective layer 20 were consist of 60 parts of fluorine-containing resin (LF-200 resin from Asahi Glass Co., Ltd.), 40 parts of titanium dioxide (R740 from Dupont China Holding Co., LTd.), 20 parts of polyester resin (NPSN resin from Nan Ya Plastics Corporation) and 8 parts of isocyanate curing agent (N3400 curing agent from Covestro Polymers Co., LTd.). The thickness of the reflective layer 20 was 15 mm, and the fluorine content thereof was 10%.

Extrusion coating was performed on the other face of the insulating layer 10, and after performing curing at a high temperature of 180°C, the undercoat layer 50 was formed. In parts by weight, raw materials of the undercoat layer 50 were consist of 40.5 parts of fluorine-containing resin (JF-3X resin from Shanghai Dongfu Chemical Technology, Co., LTd.), 40 parts of polyester resin (NPSN resin from Nan Ya Plastics Corporation), and 3 parts of isocyanate curing agent (N3400 curing agent from Covestro Polymers Co., LTd.). The thickness of the undercoat layer 50 was 3 mm, and the fluorine content thereof was 6%.

By means of a roller printing process, raw materials for forming the first decorative layer 30 were transferred onto the reflective layer 20, so as to form the first decorative layer. In parts by weight, raw materials of the first decorative layer 30 were consist of 26.1 parts of fluorine-containing resin (ZHM-2 resin from Shanghai Dongfu Chemical Technology, Co., LTd.), 12 parts of carbon black (M410 from Cabot Chemical Co., Ltd.), 30 parts of polyester resin (NPSN resin from Nan Ya Plastics Corporation) and 3.5 parts of isocyanate curing agent (N3400 curing agent from Covestro Polymers Co., LTd.). The thickness of the first decorative layer 30 was 5 mm, and the fluorine content thereof was 4%. The L value of the formed first decorative layer was 25, the a value thereof is 1, and the b value thereof is -2, and the first decorative layer had a color difference of <5% from a battery.

After extrusion coating, raw materials for forming the first transparent protective layer 40 were uniformly coated on the first decorative layer 30. And They were cured at a high temperature, and then completely covered the first decorative layer 30. In parts by weight, they were consist of 27.8 parts of fluorine-containing resin (41011 resin from Eternal Chemical (Kunshan) Co., Ltd.), 3 parts of UV absorber (UV326 from BASF AG, Germany), 3 parts of light stabilizer (Tinuvin329 from BASF AG, Germany) and 7 parts of isocyanate curing agent (N3400 curing agent from Covestro Polymers Co., LTd.). The thickness of the first transparent protective layer 40 was 20 mm, and the fluorine content thereof was 10%.

By means of a screen printing process, raw materials for forming the second decorative layer 60 were printed on the undercoat layer 50, to form the second decorative layer 60. In parts by weight, they were consist of 51.1 parts of fluorine-containing resin (JF-1X resin from Shanghai Dongfu Chemical Technology, Co., LTd.), 4 parts of organic pigment (GNX-7 from Clariant AG), 20 parts of polyester resin (NPSN resin from Nan Ya Plastics Corporation) and 4 parts of isocyanate curing agent (N3400 curing agent from Covestro Polymers Co., LTd.). The thickness of the second decorative layer 60 was 3 mm, and the fluorine content thereof was 8%.

After extrusion coating, raw materials for forming the second transparent protective layer 70 were uniformly coated on the second decorative layer 60. And they were cured at a high temperature, and then completely covered the second decorative layer 60, to obtain the second transparent protective layer 70. In parts by weight, raw materials for forming the second transparent protective layer 70 were consist of 18.2 parts of fluorine-containing resin (LF-200 resin from Asahi Glass Co., Ltd.), 10 parts of polyester resin (NPSN resin from Nan Ya Plastics Corporation), 6 parts of light stabilizer and 4.5 parts of isocyanate curing agent (N3400 curing agent from Covestro Polymers Co., Ltd.). The thickness of the second transparent protective layer 70 was 20 mm, and the fluorine content thereof was 10%.

Regarding the backplane of the described structure, the transmittance of the first transparent protective layer 40 and the second transparent protective layer 70 to ultraviolet rays at 380 nm or less was tested according to a GB/T 2410-2008 method. The test result showed that the ultraviolet transmittance of the first transparent protective layer 40 and the second transparent protective layer 70 was 0.7% and 0.6%, respectively. After irradiation aging by ultraviolet 500 kWh according to GB/T 31034-2014, the decorative layers were not faded, and the yellowing index ΔYI of the protective layers on the surfaces was 3.8; and after 3000 hours of double-85 accelerated aging (85°C, 85% humidity), the layers were not delaminated, and the whole solar assembly did not change color, which completely satisfied the outdoor use of conventional solar assemblies.

### Embodiment 3

This embodiment differs from Embodiment 1 in that: the contents of fluorine elements in the matrix resins forming the reflective layer 20 and the first decorative layer 30 were 2% and 25% respectively.

Regarding the backplane of the described structure, the transmittance of the first transparent protective layer 40 and the second transparent protective layer 70 to ultraviolet rays at 380 nm or less was tested according to a GB/T 2410-2008 method. The test result showed that the ultraviolet transmittance of the first transparent protective layer 40 and the second transparent protective layer 70 was 0.6% and 0.5%, respectively. After irradiation aging by ultraviolet 500 kWh according to GB/T 31034-2014, the decorative layers were not faded, and the yellowing index ΔYI of the protective layers on the surfaces was 8.5; and after 3000 hours of double-85 accelerated aging (85°C, 85% humidity), the layers were not delaminated, and the whole solar assembly did not change color, which completely satisfied the outdoor use of conventional solar assemblies.

### Embodiment 4

This embodiment differs from Embodiment 1 in that: the contents of fluorine elements in the matrix resins for forming the undercoat layer 50, the second decorative layer 60, the first transparent protective layer 40 and the second transparent protective layer 70 were 1%, 5%, 8% and 15% in sequence.

Regarding the backplane of the described structure, the transmittance of the first transparent protective layer 40 and the second transparent protective layer 70 to ultraviolet rays at 380 nm or less was tested according to a GB/T 2410-2008 method. The test result showed that the ultraviolet transmittance of the first transparent protective layer 40 and the second transparent protective layer 70 was 0.7% and 0.9%, respectively. After irradiation aging by ultraviolet 500 kWh according to GB/T 31034-2014, the decorative layers were not faded, and the yellowing index ΔYI of the protective layers on the surfaces was 4.1; and after 3000 hours of double-85 accelerated aging (85°C, 85% humidity), the layers were not delaminated, and the whole solar assembly did not change color, which completely satisfied the outdoor use of conventional solar assemblies.

### Embodiment 5

This embodiment differs from Embodiment 1 in that: the contents of fluorine elements in the matrix resins for forming the undercoat layer 50, the second decorative layer 60, the first transparent protective layer 40 and the second transparent protective layer 70 were 12%, 3%, 5% and 20% in sequence.

Regarding the backplane of the described structure, the transmittance of the first transparent protective layer 40 and the second transparent protective layer 70 to ultraviolet rays at 380 nm or less was tested according to a GB/T 2410-2008 method. The test result showed that the ultraviolet transmittance of the first transparent protective layer 40 and the second transparent protective layer 70 was 0.8% and 0.3%, respectively. After irradiation aging by ultraviolet 500 kWh according to GB/T 31034-2014, the decorative layers were not faded, and the yellowing index ΔYI of the protective layers on the surfaces was 10.2; and after 3000 hours of double-85 accelerated aging (85°C, 85% humidity), the layers were not delaminated, and the whole solar assembly did not change color, which completely satisfied the outdoor use of conventional solar assemblies.

### Comparative Embodiment 1

This embodiment differs from Embodiment 1 in that: the matrix resin for forming the reflective layer 20 was a fluorine-containing resin, and the matrix resin for forming the first decorative layer 30 was a polyester coating.

Regarding the backplane of the described structure, the transmittance of the first transparent protective layer 40 and the second transparent protective layer 70 to ultraviolet rays at 380 nm or less was tested according to a GB/T 2410-2008 method. The test result showed that the ultraviolet transmittance of the first transparent protective layer 40 and the second transparent protective layer 70 was 15% and 20%, respectively. After irradiation aging by ultraviolet 300 kWh according to GB/T 31034-2014, the decorative layers had faded and become yellow, and the yellowing index ΔYI of the surface layers was 18.4, which seriously exceeded the standard range; after 1500 hours of double-85 accelerated aging (85°C, 85% humidity), materials of various layers started to delaminate, and water vapor entered to form hollows, causing poor appearance.

From the description above, it can be determined that the embodiments of the present disclosure achieve the following technical effects:
By comparing Embodiments 1 to 5 and Comparative Embodiment 1, it can be determined that the photovoltaic module backplane prepared in some embodiments of the present disclosure has better delamination resistance, weather resistance and ultraviolet blocking performance.

By comparing Embodiments 1 to 3, it can be determined that defining the contents of fluorine elements in the matrix resins of the reflective layer and the first decorative layer within the preferred range of some embodiments of the present disclosure facilitates improvement of the delamination resistance and weather resistance of the photovoltaic module backplane.

By comparing Embodiments 1, 4 and 5, it can be determined that defining the contents of fluorine elements in the matrix resins of the undercoat layer, the second decorative layer, the first transparent protective layer and the second transparent protective layer within the preferred range of some embodiments of the present disclosure facilitates improvement of the delamination resistance and weather resistance of the photovoltaic module backplane.

It is to be noted that terms "first", "second" and the like in the description and claims of the present disclosure are used for distinguishing similar objects rather than describing a specific sequence or a precedence order. It should be understood that the terms so used may be interchanged where appropriate so that the embodiments of the present disclosure described herein can be implemented in sequences other than those illustrated or described herein.

## Claims

1. A photovoltaic module backplane, the photovoltaic module backplane comprising an insulating layer (10), a reflective layer (20), a first decorative layer (30) and a first transparent protective layer (40) which are stacked in sequence, wherein matrix resins of the reflective layer (20) and the first decorative layer (30) are fluorine-containing resins.

2. The photovoltaic module backplane according to claim 1, wherein the fluorine-containing resin is a copolymerized fluororesin containing tetrafluoroethylene chain segments and/or chlorotrifluoroethylene chain segments;
preferably, the contents of fluorine elements in the matrix resins of the reflective layer (20) and the first decorative layer (30) are 3 to 15 wt% and 5 to 20 wt% in sequence.

3. The photovoltaic module backplane according to claim 2, wherein raw materials for forming the first decorative layer (30) further comprise a pigment, the L value of the pigment is 10 to 70, the a value of the pigment is -20 to 20, and the b value of the pigment is -40 to 0, and the difference between the Lab value of the pigment and the Lab value of a target battery cell is ±5%.

4. The photovoltaic module backplane according to claim 2 or 3, wherein the photovoltaic module backplane further comprises:
an undercoat layer (50), the undercoat layer (50) being provided on the surface of the insulating layer (10) away from the reflective layer (20); and
a second decorative layer (60), the second decorative layer (60) being provided on the surface of the undercoat layer (50) away from the insulating layer (10).

5. The photovoltaic module backplane according to claim 4, wherein the photovoltaic module backplane further comprises a second transparent protective layer (70), wherein the second transparent protective layer (70) is provided on the surface of the second decorative layer (60) away from the undercoat layer (50).

6. The photovoltaic module backplane according to claim 5, wherein the first transparent protective layer (40) has a thickness of 1 to 20 µm, and the second transparent protective layer (70) has a thickness of 10 to 50 µm.

7. The photovoltaic module backplane according to claim 1, wherein raw materials for forming the reflective layer (20) comprise a white filler and a dispersant, and preferably, based on 100 parts by weight, in the raw materials for forming the reflective layer (20), the amount of the white filler is 10 to 50 parts, and the amount of the dispersant is 0.5 to 5 parts.

8. A photovoltaic module, comprising a backplane, wherein the backplane is the photovoltaic module backplane according to any one of claims 1-7.

## Patentansprüche

1. Rückwandplatine für ein fotovoltaisches Modul, wobei die Rückwandplatine für ein fotovoltaisches Modul eine Isolierschicht (10), eine Reflexionsschicht (20), eine erste Zierschicht (30) und eine erste transparente Schutzschicht (40) umfasst, die der Reihe nach gestapelt sind, wobei Matrixharze der Reflexionsschicht (20) und der ersten Zierschicht (30) fluorhaltige Harze sind.

2. Rückwandplatine für ein fotovoltaisches Modul nach Anspruch 1, wobei das fluorhaltige Harz ein copolymerisiertes Fluorharz ist, das Tetrafluorethylenkettensegmente und/oder Chlortrifluorethylenkettensegmente enthält;
vorzugsweise wobei der Gehalt von Fluorelementen in den Matrixharzen der Reflexionsschicht (20) und der ersten Zierschicht (30) der Reihe nach 3 bis 15 Gew.-% und 5 bis 20 Gew.-% beträgt.

3. Rückwandplatine für ein fotovoltaisches Modul nach Anspruch 2, wobei Rohmaterialien zur Ausbildung der ersten Zierschicht (30) ferner ein Pigment umfassen, der L-Wert des Pigments 10 bis 70 ist, der a-Wert des Pigments -20 bis 20 ist und der b-Wert des Pigments -40 bis 0 ist und sich der Unterschied zwischen dem Lab-Wert des Pigments und dem Lab-Wert einer Zielbatteriezelle ± 5 % beträgt.

4. Rückwandplatine für ein fotovoltaisches Modul nach Anspruch 2 oder 3, wobei die Rückwandplatine für ein fotovoltaisches Modul ferner umfasst:
eine Grundierungsschicht (50), wobei die Grundierungsschicht (50) auf der Oberfläche der Isolierschicht (10) abseits der Reflexionsschicht (20) vorgesehen ist; und
eine zweite Zierschicht (60), wobei die zweite Zierschicht 60) auf der Oberfläche der Grundierungsschicht (50) abseits der Isolierschicht (10) vorgesehen ist.

5. Rückwandplatine für ein fotovoltaisches Modul nach Anspruch 4, wobei die Rückwandplatine für ein fotovoltaisches Modul ferner eine zweite transparente Schutzschicht (70) umfasst, wobei die zweite transparente Schutzschicht (70) auf der Oberfläche der zweiten Zierschicht (60) abseits der Grundierungsschicht (50) vorgesehen ist.

6. Rückwandplatine für ein fotovoltaisches Modul nach Anspruch 5, wobei die erste transparente Schutzschicht (40) eine Dicke von 1 bis 20 µm aufweist und die zweite transparente Schutzschicht (70) eine Dicke von 10 bis 50 µm aufweist.

7. Rückwandplatine für ein fotovoltaisches Modul nach Anspruch 1, wobei Rohmaterialien zum Ausbilden der Reflexionsschicht (20) einen weißen Füllstoff und ein Dispergiermittel umfassen und vorzugsweise die Menge des weißen Füllstoffs in den Rohmaterialien zum Ausbilden der Reflexionsschicht (20) bezogen auf 100 Gewichtsteile 10 bis 50 Teile und die Menge des Dispergiermittels 0,5 bis 5 Teile beträgt.

8. Fotovoltaisches Modul, das eine Rückwandplatine umfasst, wobei die Rückwandplatine die Rückwandplatine für ein fotovoltaisches Modul nach einem der Ansprüche 1 bis 7 ist.

## Revendications

1. Feuille arrière de module photovoltaïque, la feuille arrière de module photovoltaïque comprenant une couche isolante (10), une couche réfléchissante (20), une première couche décorative (30) et une première couche protectrice transparente (40) qui sont empilées en séquence, les résines de matrice de la couche réfléchissante (20) et de la première couche décorative (30) étant des résines contenant du fluor.

2. Feuille arrière de module photovoltaïque selon la revendication 1, dans laquelle la résine contenant du fluor est une résine fluorée copolymérisée contenant des segments de chaîne de tétrafluoroéthylène et/ou des segments de chaîne de chlorotrifluoroéthylène ;
préférablement, les teneurs en éléments fluorés dans les résines de matrice de la couche réfléchissante (20) et de la première couche décorative (30) sont de 3 à 15 % en poids et de 5 à 20 % en poids en séquence.

3. Feuille arrière de module photovoltaïque selon la revendication 2, dans laquelle les matières premières pour former la première couche décorative (30) comprennent en outre un pigment, la valeur L du pigment est de 10 à 70, la valeur a du pigment est de -20 à 20, et la valeur b du pigment est de - 40 à 0, et la différence entre la valeur Lab du pigment et la valeur Lab d'une cellule de batterie cible est de ±5%.

4. Feuille arrière de module photovoltaïque selon la revendication 2 ou 3, dans laquelle la feuille arrière de module photovoltaïque comprend en outre :
une sous-couche (50), la sous-couche (50) étant disposée sur la surface de la couche isolante (10) à l'opposé de la couche réfléchissante (20) ; et
une seconde couche décorative (60), la seconde couche décorative (60) étant disposée sur la surface de la sous-couche (50) à l'opposé de la couche isolante (10).

5. Feuille arrière de module photovoltaïque selon la revendication 4, dans laquelle la feuille arrière de module photovoltaïque comprend en outre une seconde couche protectrice transparente (70), la seconde couche protectrice transparente (70) étant disposée sur la surface de la seconde couche décorative (60) à l'opposé de la sous-couche (50).

6. Feuille arrière de module photovoltaïque selon la revendication 5, dans laquelle la première couche protectrice transparente (40) a une épaisseur de 1 à 20 µm, et la seconde couche protectrice transparente (70) a une épaisseur de 10 à 50 µm.

7. Feuille arrière de module photovoltaïque selon la revendication 1, dans laquelle les matières premières pour former la couche réfléchissante (20) comprennent une charge blanche et un dispersant, et préférablement, sur la base de 100 parties en poids, dans les matières premières pour former la couche réfléchissante (20), la quantité de charge blanche est de 10 à 50 parties, et la quantité de dispersant est de 0,5 à 5 parties.

8. Module photovoltaïque, comprenant une feuille arrière, dans lequel la feuille arrière est la feuille arrière de module photovoltaïque selon l'une quelconque des revendications 1 à 7.
